# EUROPEAN PATENT APPLICATION

(11) **EP 0 632 492 A2**
(43) Date of publication of application: **04.01.1995**
(21) Application number: 94304642.5
(22) Date of filing: 27.06.1994
(51) Int. Cl.: H01L 21/336, H01L 21/283, H01L 29/786, H01L 27/11, H01L 21/8244

(54) **Method of forming self-aligned LDD structures and low resistance contacts in thin film transistor technology devices**

(30) Priority: 30.06.1993 US 85297
(71) Applicant: SGS-THOMSON MICROELECTRONICS, INC., Carrollton Texas 75006 (US)
(72) Inventor: Hodges, Robert Louis, Euless, Texas 76040 (US); Sundaresan, Ravishankar, Garland, Texas 75040 (US)
(74) Representative: Palmer, Roger

(57) **Abstract**

A prior art thin film transistor structure having a first and a second polycrystalline silicon layer of different conductivity types (P and N) has a high resistance contact at the resultant P-N junction. This contact resistance is reduced by forming TiSi₂ (titanium disilicide) or other refractory metal silicides such as cobalt or molybdenum in specific regions, namely the P-N junction contact. Titanium disilicide consumes the portion of the second polycrystalline silicon layer in the P-N contact junction and at the same time consumes a small portion of the underlying first polycrystalline silicon layer, such that the high resistance P-N junction now no longer exists.

The procedure to form low resistance contacts is extended to achieve a low leakage polysilicon TFT device. One or more LDD regions are formed to reduce the amount of leakage current of such transistor devices in an "OFF" state. The source/drain region(s) of the device are implanted with a first dopant type followed by an etch which forms spacers above the source/drain regions. Then, the source/drain regions are implanted with a second dopant type so that LDD regions are formed beneath the spacers. The electric field at the gate and source/drain boundaries of the device is spread over the entire LDD region, resulting in a lower peak electric field and hence less device leakage current.

## Description

The present invention relates generally to semiconductor integrated circuit processing, and more specifically to a thin film transistor (TFT) structure having low contact resistance at the P-N junction or diode where contact or interconnect between at least two regions having different conductivity type occurs and to such a structure further having self-aligned lightly doped drain (LDD) structures.

This application is related to European Patent Application No 94303007.2, the contents of which are incorporated herein by this cross reference.

PN diode interconnection technology, such as thin-film transistor (TFT) or polycrystalline silicon technology, is used in SRAM and video display technology because of the high density advantage it provides. In thin-film transistor technology, P-channel polycrystalline silicon transistors are generally used as the PMOS load with the NMOS drivers and passgates built in the single crystal substrate. The use of P-channel polysilicon transistors as the load for the SRAM cell usually results in better electrical characteristics than polysilicon resistors, and they are typically faster than resistive loads. Additionally, P-channel transistors provide greater immunity to noise.

In spite of the benefits associated with the use of polycrystalline silicon P-channel transistors as load transistors, a disadvantage arises when interconnection between polycrystalline silicon lines having different conductivity types occurs, causing high resistance contacts to be formed. TFT technology of three polycrystalline silicon layers of different conductivity types will result in polycrystalline silicon interconnect lines of different conductivity making contact. For instance, interconnection between a P+ polycrystalline silicon layer and an adjacent N+ polycrystalline silicon layer results in a high resistance contact being formed at the resultant P-N junction. In a three layer polycrystalline silicon transistor, with the second and third layers composed of N+ and P+ materials, respectively, a high resistance contact is formed at the P-N junction between the second and third polycrystalline silicon layers.

Yet another problem often encountered in polysilicon TFT technology is leakage current. At the boundary between the gate and drain regions of a transistor, there can be a large electric field present when the transistor is in an "OFF" state. This, combined with electron trapping at grain boundaries in the substrate, will often result in a high level of leakage current in the device.

As a result of these well known problems associated with TFT technology, it would be desirable to decrease the contact resistance at the P-N junction and to reduce leakage current associated with TFT devices.

It is therefore an object of the present invention to reduce the contact resistance at the P-N junction of a TFT structure.

It is further an object of the present invention to address leakage current problems often present in such TFT structures.

A prior art thin film transistor (TFT) structure having a first and a second polycrystalline silicon layer of different conductivity types (P and N) has a high resistance contact at the resultant P-N junction. This contact resistance is reduced by forming TiSi₂ (titanium disilicide) or other refractory metal silicides such as cobalt or molybdenum in specific regions, namely the P-N junction contact. Titanium disilicide consumes the portion of the second polycrystalline silicon layer in the P-N contact junction and at the same time consumes a small portion of the underlying first polycrystalline silicon layer, such that the high resistance P-N junction now no longer exists.

The procedure to form low resistance contacts is extended to achieve a low leakage polysilicon TFT device. One or more LDD regions are formed to reduce the amount of leakage current of such transistor devices in an "OFF" state. The source/drain region(s) of the device are implanted with a first dopant type followed by an etch which forms spacers above the source/drain regions. Then, the source/drain regions are implanted with a second dopant type so that LDD regions are formed beneath the spacers. The electric field at the gate and source/drain boundaries of the device is spread over the entire LDD region, resulting in a lower peak electric field and hence less device leakage current.

According to a first aspect of the present invention there is provided a method of forming a portion of a thin film transistor integrated circuit, comprising forming a first polycrystalline silicon layer having a first conductivity type, forming a second polycrystalline silicon layer having a second conductivity type and having a contact region with the first polycrystalline silicon layer, forming an insulating layer over the second polycrystalline silicon layer, converting the second polycrystalline silicon layer in the contact region, and a portion of the first polycrystalline silicon layer in the contact region, to a silicide, and forming a self-aligned lightly doped drain (LDD) region of a thin film transistor (TFT).

The step of forming a LDD region may further comprise the steps of implanting the insulating layer with a P⁻⁻ dopant material, implanting the source/drain regions of the insulating layer with a P⁻ dopant material, forming spacers over the source/drain regions of the TFT, implanting the source/drain regions of the TFT with a P⁺ dopant material and patterning and etching the second polycrystalline silicon layer.

Preferably the implant steps may be performed with Boron, BF2 or Indium dopant material.

Preferably the insulating layer is implanted with a P⁻⁻ dosage of approximately 1 x 10¹⁶ per cm³.

Preferably the source/drain regions of the second insulating layer are implanted with a P⁻ dosage of approximately 1 x 10¹⁷ per cm³.

Preferably the source/drain regions of the TFT are implanted with a P⁺ dosage of between approximately 1 x 10²¹ per cm³.

The step of forming a LDD region may comprise the steps of implanting the insulating layer with a P⁻ dopant material, forming spacers over the source/drain regions of the TFT implanting the source/drain regions of the TFT with a P⁺ dopant material and patterning and etching the second polycrystalline silicon layer.

Preferably the implant steps may be performed with Boron, BF2 or Indium dopant material.

Preferably the insulating layer is implanted with a P⁻ dosage of approximately 1 x 10¹⁷ per cm³.

Preferably the source/drain regions of the TFT are implanted with a P⁺ dosage of between approximately 1 x 10¹⁹ to 1 x 10²¹ per cm³.

The step of forming a LDD region may further comprise the steps of implanting the source/drain regions of the insulating layer with a P⁻ dopant material, forming spacers over the source/drain regions of the TFT implanting the source/drain regions of the TFT with a P⁺ dopant material, and patterning and etching the second polycrystalline silicon layer.

Preferably the implant steps may be performed with Boron, BF2 or Indium dopant material.

Preferably the source/drain regions of the insulating layer are implanted with a P⁻ dosage of approximately 1 x 10¹⁷ per cm³.

Preferably the source/drain regions of the TFT are implanted with a P⁺ dosage of between approximately 1 x 10¹⁹ to 1 x 10²¹ per cm³.

According to a second aspect of the present invention there is provided a portion of a thin film transistor integrated circuit structure, comprising a first polycrystalline silicon layer having a first conductivity type, an insulating layer with an opening which exposes a portion of the first polycrystalline silicon layer, a second polycrystalline silicon layer haviing a second conductivity type and having a contact region with the first polycrystalline silicon layer, a metal silicide which fills the contact region and a lightly doped drain (LDD) region of the TFT structure.

The novel features believed characteristic of the invention are set forth in the appended claims. The invention itself however, as well as a preferred mode of use, and further objects and advantages thereof, will best be understood by reference to the following detailed description of an illustrative embodiment when read in conjunction with the accompanying drawings, wherein:

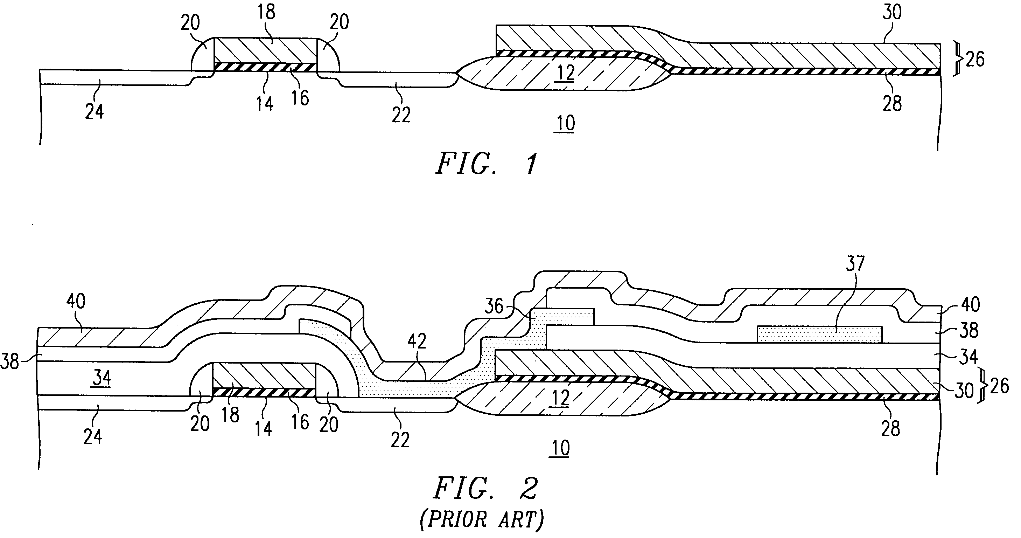

**Figures 1-9** illustrate a preferred method for forming a P-N junction with reduced resistance and with self-aligned LDD structures, according to the present invention.

The process steps and structures described below do not form a complete process flow for manufacturing integrated circuits. Rather, the present invention may be practiced in conjunction with integrated circuit fabrication techniques currently known in the art, and only so much of the commonly practiced process steps are included as are necessary to provide an understanding of the present invention. The figures representing cross-sections of portions of an integrated circuit during fabrication are not drawn to scale, but instead are drawn so as to illustrate the important features of the present invention.

Referring to **Figure 1**, an integrated circuit device is to be formed in a silicon substrate 10. Selected regions of the substrate 10 are oxidized to form a field oxide insulating region 12. A first N-channel field effect device 14 having a gate oxide layer 16, a first gate electrode 18, sidewall oxide spacers 20 and source/drain regions 22, 24 are manufactured by methods well known in the art. A second N-channel field effect device 26 is formed by methods known in the art having a gate oxide layer 28 and a second gate electrode 30; gate oxide layer 28 is formed at the same time that gate oxide layer 16 of device 14 is formed. As with the first N-channel field effect device 14, the second N-channel field effect device 26 is generally formed from a first polycrystalline silicon layer. The source/drain region 22 of device 14 and the gate electrode 30 form the interconnected conductive structures of the N-channel devices.

Referring to **Figure 2**, a first oxide insulating layer 34 is formed over the integrated circuit by known methods. Insulating layer 34 is patterned and etched to expose a portion of the underlying conductive structure source/drain region 22 of device 14. A portion of the second gate electrode 30 of the second N-channel device 26 may also be exposed during the patterning and etching steps. Source/drain region 22 of the first N-channel field effect device is typically implanted with an N+ type dopant such as arsenic or phosphorus. Gate electrode 30 is usually in-situ doped or phosphorous doped using POCl₃ during a phosphorous deposition.

Second gate electrode and polycrystalline silicon layer 30 is patterned and etched prior to chemical vapor deposition (CVD) of oxide 34 onto polycrystalline silicon layer 30 in the range of 300 to 2000 Angstroms. Polycrystalline silicon layer 36 is then deposited on the device and etched to define interconnect regions, followed by a thin film transistor gate implant of phosphorous of greater than 1x10¹⁹/cm³ which makes polycrystalline silicon layer 36 N+ conductivity material; phosphorous or other N+ - type material could also be deposited instead of implanted. Polycrystalline silicon layer 37 will form the gate of a transistor which is not shown here. Besides phosphorous, another N+ dopant material which could be used is arsenic. Next thin film transistor gate oxide deposition results in oxide insulating layer 38 which is followed by gate oxide densification. Densification of oxide insulating layer 38 could be performed in diluted O₂, N₂, or H₂O.

For the TFT technology shown in **Figure 2**, the shared contact between polycrystalline silicon layers 36 and 40 is formed when oxide layer 38 is deposited on polycrystalline silicon layer 36 and then patterned and etched. Amorphous silicon is deposited followed by solid phase epitaxial growth (SPG) anneal to form polycrystalline silicon layer 40. Amorphous deposition of silicon, with large grains as close to a single crystal transistor as possible, is desired. Therefore, low temperature poly deposition of less than 600 degrees Celsius is used; laser recrystallization and anneal can also be used to enhance grain size. Additionally, hydrogen passivation can be performed to enhance device integrity. If desired, thin film transistor channel implantation may be performed.

Next, polycrystalline silicon layer 40 is patterned and etched by methods known in the art. Since polycrystalline silicon layers 36 and 40 have different conductivity types, the resultant P-N junction 42 between polycrystalline silicon layers 36 and 40 is a high resistance contact junction. The prior art structure of **Figure 2** has an undesirable high resistance contact at P-N junction 42. Applicant's invention proposes to reduce the contact resistance by forming TiSi₂ (titanium disilicide) or other refractory metal silicides such as cobalt or molybdenum in specific regions, namely the P-N junction contact.

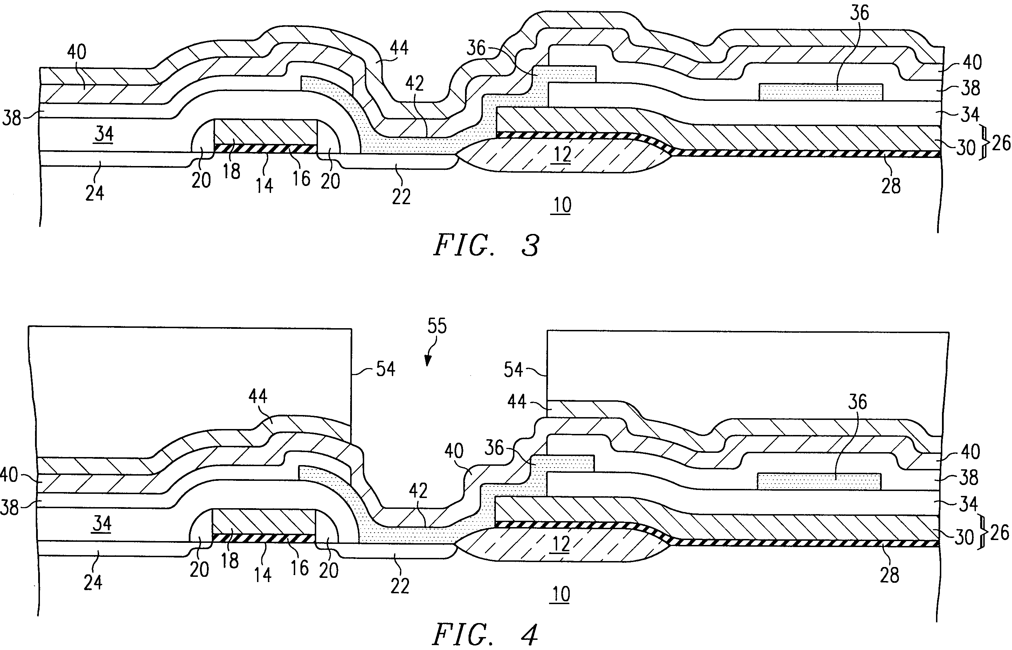

Referring now to **Figure 3**, a silicon nitride insulating layer 44 is deposited over polycrystalline silicon layer 40. Silicon nitride layer 44 typically has a thickness on the order of approximately 50 to 500 angstroms. Layer 44 may also be silicon dioxide.

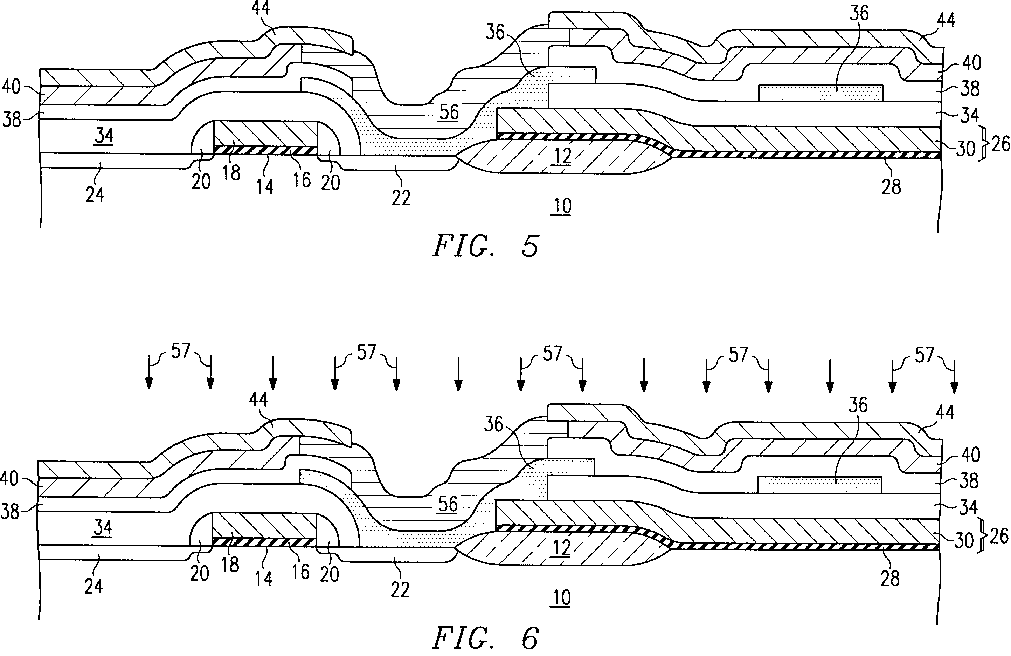

As shown in **Figure 4**, photoresist 54 is positioned to create a salicide mask opening 55 such that the contact formed at P-N junction 42 between polycrystalline silicon layers 36 and 40 may be patterned and then subjected to a silicon nitride, or silicon dioxide, etch and resist strip. Next, as illustrated in **Figure 5**, titanium is deposited over polycrystalline silicon layer 40 followed by rapid thermal annealing to form titanium disilicide in the P-N junction contact 42; besides titanium, other refractory metals such as cobalt or molybdenum may be used to form a metal silicide. Annealing of the titanium may also be performed in a 600 - 800 degree Celsius furnace. As titanium disilicide is being formed, a layer of titanium nitride is formed on top of the deposited layer of titanium. It is desirable to maximize the thickness of the titanium disilicide while minimizing the thickness of the titanium nitride. By varying the temperature and ambient gas during the anneal, it is possible to control the thickness of titanium nitride and titanium disilicide combinations.

Next, the titanium nitride layer is stripped away in a combination of sulfuric acid and hydrogen peroxide to leave titanium disilicide layer 56 in the P-N junction contact 42. Titanium disilicide layer 56 consumes the portion of polycrystalline silicon layer 40 in the P-N contact junction 42 and at the same time consumes a small portion of the underlying polycrystalline silicon layer 36, such that P-N junction 42 now no longer exists. In this way, the contact between polycrystalline silicon layers 36 and 40 having different conductivity types is shorted out and, therefore, the contact resistance between them is drastically reduced.

Process steps, corresponding to Figures 1 to 5, for forming a P-N junction having reduced resistance have been described above. Additional process steps may be used to form self-aligned lightly doped drain (LDD) structures and will now be described in conjunction with Figures 6 to 9.

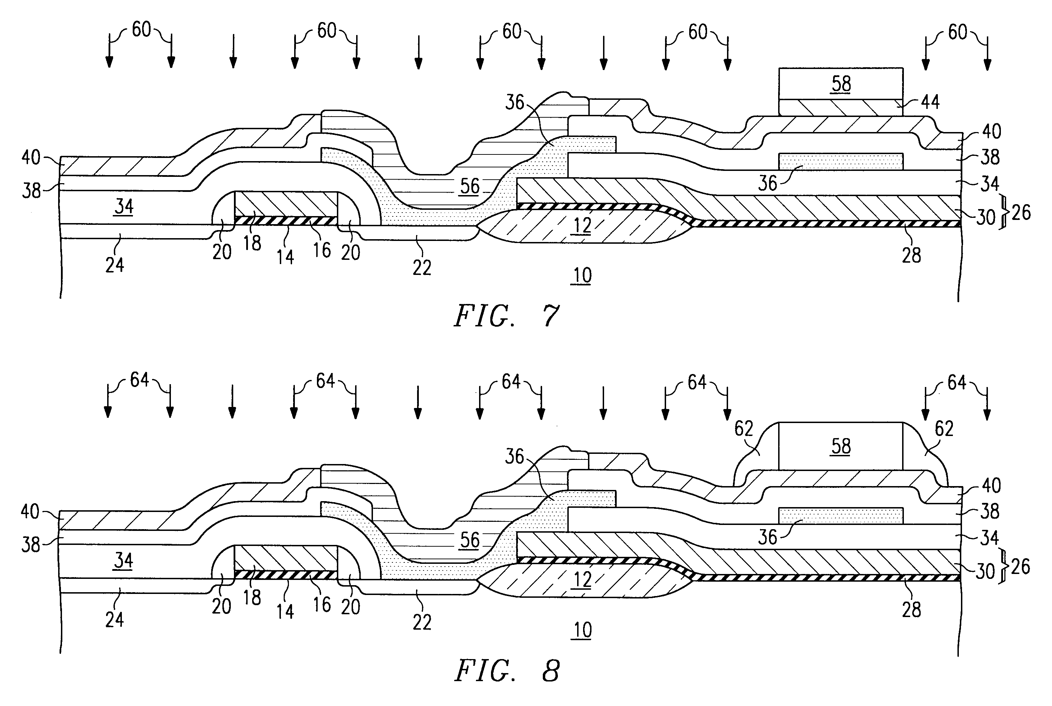

Referring now to **Figure 6**, a first preferred embodiment for forming LDD structures having reduced leakage current is described. The entire layer 44 is implanted 57 with P⁻⁻ dopant material, such as Boron, BF2, or Indium, at dosages of approximately 1 x 10¹⁶ per cm³. Next, as shown in **Figure 7**, photoresist 58 is placed over the gate portion of silicon nitride layer 44. As discussed previously, layer 44 may be silicon dioxide as well as silicon nitride. Portions of silicon nitride layer 44 which are not protected by photoresist 58 are next patterned and etched away, as shown in **Figure 7**. The source/drain regions are implanted 60 with P⁻ dopant materials such as Boron, at dosages of approximately 1 x 10¹⁷ per cm³.

Next, chemical vapor deposition (CVD) of silicon nitride or silicon dioxide is performed. The resulting silicon nitride or silicon dioxide layer has a thickness of between approximately 100 to 3000 Angstroms. A blanket etch is performed to form spacers 62 shown in **Figure 8**. Spacers 62 are silicon nitride or silicon dioxide, depending on which material is deposited in the CVD. Source/drain regions of the device are implanted with a dosage of P⁺ material, such as Boron, at concentrations of between approximately 1 x 10¹⁹ to 1 x 10²¹ per cm³. As a result LDD regions are formed directly under spacers 62 and photoresist 58 in polycrystalline silicon layer 40. These regions are self-aligned with respect to the gate region due to the fact that photoresist 58 of **Figure 7** was placed over the gate portion of silicon nitride layer 44 before source/drain regions were implanted with P⁻ material. The portion of polycrystalline silicon layer 40 under photoresist 58 is P⁻⁻ material because of the P⁻⁻ implant of **Figure 6**, while the portions of polycrystalline silicon layer 40 under spacers 62 is P⁻ because of the P⁻ implant of these regions as shown in **Figure 7**.

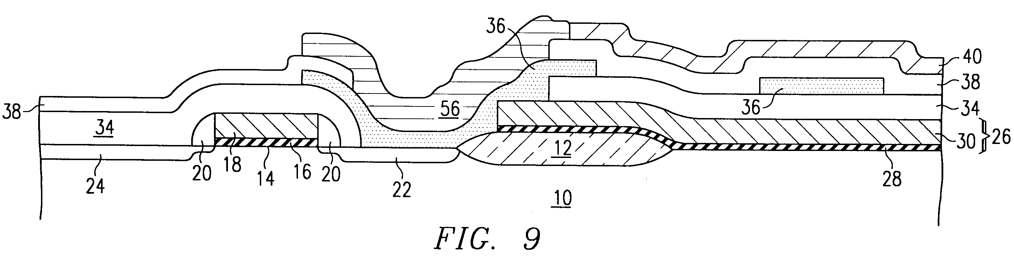

Finally, **Figure 9** shows the result of etching oxide spacers 62 and photoresist 58, followed by patterning and etching polycrystalline silicon layer 40 to improve the planarity of the resultant device. Patterning and etching polycrystalline silicon layer 40 at this stage has the effect of removing silicon nitride layer 44 such that the topography of the transistor device is reduced. Topography reduction may be important in those high density devices where TFT technology is utilized. Additional, standard process steps well known in the art may now be applied.

The formation of LDD regions addresses the prior art problem of leakage current. The electric charge buildup which occurs between the gate and source/drain boundaries of the device is spread over the entire LDD region, resulting in less device leakage current. This is a definite improvement over the prior art device where the electric field is concentrated in a smaller area and thus leads to greater electric charge buildup. The presence of P⁻⁻ material in the portion of the LDD region under photoresist 58 and P⁻ material in the portion of the LDD region under spacers 62 further facilitates the prevention of electric field buildup and therefore makes possible a higher driver current for the device.

As described above, implantation of a TFT device may be accomplished with P⁻⁻, P⁻, or P⁺ materials, such as Boron, BF2, or Indium. These implants may occur at dosage concentrations of between approximately 1 x 10¹⁶ to 1 x 10²¹ per cm³. The three implant steps outlined above and shown in Figures 6, 7, and 8 allow for electric field energy to be easily dissipated over a relatively large area which consists of the portions of polycrystalline silicon region 40 under photoresist 58 and spacers 62, thereby limiting the amount of device leakage current that will result and increasing the output driver current of the device in an "ON" state.

In addition to this LDD formation scheme, the present invention provides for other implantation methodologies as well. As a second preferred embodiment, the P⁻⁻ implant 57 of **Figure 6** may be replaced with a P⁻ implant of the entire layer 44 at dosages of approximately 1 x 10¹⁷ per cm³. The P⁻ implant 60 of **Figure 7** is not performed. Next, the P⁺ implant shown and described in conjunction with **Figure 8** is performed. The resultant LDD region would have a P⁻ region in the portion of polycrystalline silicon layer 40 under photoresist 58 and under both spacers 62. While the distribution of electrical field energy is better for the first embodiment than the second embodiment, the first embodiment requires the use of additional precision maskworks, making it more costly and time consuming to produce. The second preferred embodiment still provides minimization of leakage current.

A third preferred embodiment, similar to the second preferred embodiment in that only two implantation steps are required, may be used. In this embodiment, implant 57 of the entire layer 44 as shown in **Figure 6** is not performed. Rather, the P⁻ and the P⁺ implant steps of Figures 7 and 8, respectively, are performed to form two LDD regions: one under each spacer 62. These LDD regions do contribute to the minimization of leakage current for a TFT device, but are not as effective in this regard as either the first embodiment or the second embodiment because there are two smaller areas over which to distribute the electric field. On the other hand, an advantage of the third preferred embodiment is that fewer implantation steps are required.

The formation of LDD regions addresses leakage current concerns for a transistor in an "OFF" state. However, LDD regions also introduce increased resistance which can decrease the current of a transistor in an "ON" state. Forming a spacer on only one side of the transistor can address this concern. A photo resist mask placed over the source/drain region of one side of the device prior to CVD of silicon dioxide or silicon nitride will mean that only one spacer 62 is formed. As a result, the current of the transistor while in an "ON" state is not reduced to the extent it would be if two spacers were formed, and one LDD region will still reduce leakage current when the device is in an "OFF" state.

A process for manufacturing TFT devices having PN contacts or junctions has been described. The process addresses two common problems with PN junction devices. First, a metal or metal silicide interconnect layer is formed as a shared contact between layers of different conductivity types, thereby preventing high resistance P-N junctions from forming. Additionally, a self-aligned LDD region or regions is formed to reduce the amount of leakage current of such devices while in an "OFF" state.

While the invention has been particularly shown and described with reference to a preferred embodiment, it will be understood by those skilled in the art that various changes in form and detail may be made therein without departing from the spirit and scope of the invention.

## Claims

1. A method of forming a portion of a thin film transistor integrated circuit, comprising:
forming a first polycrystalline silicon layer having a first conductivity type;
forming a second polycrystalline silicon layer having a second conductivity type and having a contact region with the first polycrystalline silicon layer;
forming an insulating layer over the second polycrystalline silicon layer;
converting the second polycrystalline silicon layer in the contact region, and a portion of the first polycrystalline silicon layer in the contact region, to a silicide; and
forming a self-aligned lightly doped drain (LDD) region of a thin film transistor (TFT).

2. The method of claim 1, wherein the step of forming a LDD region further comprises the steps of:
implanting the insulating layer with a P⁻⁻ dopant material;
implanting the source/drain regions of the insulating layer with a P⁻ dopant material;
forming spacers over the source/drain regions of the TFT;
implanting the source/drain regions of the TFT with a P⁺ dopant material; and
patterning and etching the second polycrystalline silicon layer.

3. The method of claim 1, wherein the step of forming a LDD region further comprises the steps of:
implanting the insulating layer with a P⁻ dopant material;
forming spacers over the source/drain regions of the TFT;
implanting the source/drain regions of the TFT with a P⁺ dopant material; and
patterning and etching the second polycrystalline silicon layer.

4. The method of claim 1, wherein the step of forming a LDD region further comprises the steps of:
implanting the source/drain regions of the insulating layer with a P⁻ dopant material;
forming spacers over the source/drain regions of the TFT;
implanting the source/drain regions of the TFT with a P⁺ dopant material; and
patterning and etching the second polycrystalline silicon layer.

5. The method of claim 1, wherein a first insulating layer is formed over a portion of the first polycrystalline silicon layer and is patterned and etched to expose a portion of the first polycrystalline silicon layer, and wherein the second polycrystalline silicon layer makes contact with the first polycrystalline silicon layer through the exposed portion of the first polycrystalline silicon layer.

6. The method of claim 1, wherein the step of converting the second polycrystalline silicon layer to silicide comprises the steps of:
fornming a refractory metal layer over the second polycrystalline silicon layer; and
annealing the refractory metal layer so as to form the metal silicide in the contact region.

7. The method of claim 6, wherein prior to the converting step, a second insulating layer is formed over the second polycrystalline silicon layer in the contact region so as to confine the convereting step to the contact region.

8. A portion of a thin film transistor integrated circuit structure, comprising:
a first polycrystalline silicon layer having a first conductivity type;
an insulating layer with an opening which exposes a portion of the first polycrystalline silicon layer;
a second polycrystalline silicon layer haviing a second conductivity type and having a contact region with the first polycrystalline silicon layer;
a metal silicide which fills the contact region; and
a lightly doped drain (LDD) region of the TFT structure.

9. The structure of claim 8, wherein the LDD region of the TFT structure is P⁻ material.

10. The structure of claim 8, wherein the LDD region of the TFT structure is P⁻ material in the source/drain regions of the TFT structure and is P⁻⁻ material under the gate of the TFT structure.

11. The structure of claim 8, wherein a lower insulating layer is formed over a substrate such that the first polycrystalline silicon layer is formed over the lower insulating layer and the lower insulating layer has an opening through which the first polycrystalline silicon layer has contact with a conductive region of the substrate.

12. The structure of claim 11, wherein the conductive region of the substrate is a source/drain region of a field effect device.

13. The structure of claim 8, wherein the second polycrystalline silicon layer has a large grain size characteristic of amorphous silicon having been deposited, recrystallized and annealed.

14. The structure of claim 8, wherein the metal silicide is a refractory metal silicide.
